Europäisches Patentamt

European Patent Office

Office européen des brevets

(19)

(11) Veröffentlichungsnummer: **0 032 264**
**B1**

(12)

# EUROPÄISCHE PATENTSCHRIFT

(45) Veröffentlichungstag der Patentschrift:
**22.05.85**

(21) Anmeldenummer: **80201206.2**

(22) Anmeldetag: **18.12.80**

(51) Int. Cl.⁴: **H 01 L 29/743, H 01 L 29/60**

(54) **Thyristor mit kurzgeschlossenem Emitter für kurze Stromflussdauer.**

(30) Priorität: **11.01.80 DE 3000804**

(43) Veröffentlichungstag der Anmeldung:
**22.07.81 Patentblatt 81/29**

(45) Bekanntmachung des Hinweises auf die Patenterteilung:
**22.05.85 Patentblatt 85/21**

(84) Benannte Vertragsstaaten:
**CH FR GB LI SE**

(56) Entgegenhaltungen:
**DE - A - 2 748 528**
**US - A - 3 638 080**
**US - A - 4 060 825**
**US - A - 4 176 371**

(73) Patentinhaber: **SEMIKRON, GESELLSCHAFT FÜR GLEICHRICHTERBAU UND ELEKTRONIK M.B.H., Sigmundstrasse 200, D-8500 Nürnberg 82 (DE)**

(72) Erfinder: **Tursky, Werner, Dr. Dipl.-Ing., Aldringerstrasse 15, D-8500 Nürnberg (DE)**

ACTORUM AG

## Beschreibung

Die Erfindung betrifft einen Thyristor mit kurzgeschlossenem Emitter für kurze Stromflussdauer, bei welchem der durch die Stromflussdauer bestimmte Bereich der Zündausbreitung frei von Durchbrüchen der Basiszone durch die Emitterzone ist.

Bekannte Ausführungsformen von Thyristoren weisen einen scheibenförmigen Halbleiterkörper auf, dessen Emitterfläche mit vielen, über die Fläche verteilten Durchbrüchen versehen ist. Eine derartige Anordnung der Durchbrüche beeinträchtigt insbesondere bei kurzer Stromflussdauer die Zündausbreitung.

Weiter sind Bauformen bekannt, deren Halbleiterkörper nur in der äusseren, von der Steuerelektrode entfernten Randzone mit fein verteilten Durchbrüchen versehen ist. Eine solche Anordnung zeigt wohl die gewünschte Zündausbreitung, genügt aber nicht allen Anforderungen an das du/dt-Verhalten. Da jedoch die Strombelastbarkeit und damit auch die Überstrombelastbarkeit durch die gesamte Emitterfläche bestimmt wird, und da der von Durchbrüchen freie Flächenbereich mit Rücksicht auf die Notwendigkeit eines optimalen dynamischen Verhaltens nicht beliebig gross gemacht werden kann, erfüllt eine solche Ausgestaltung nicht die generelle Forderung nach hoher Überstrombelastbarkeit.

Der Erfindung lag die Aufgabe zugrunde, Thyristoren für kurze Stromflussdauer zu schaffen, die optimales Durchschaltverhalten und hohe Überstrombelastbarkeit aufweisen.

Die Lösung dieser Aufgabe besteht bei einem Thyristor der eingangs genannten Art darin, dass die Emitterzone in einer durch die vorgesehene Stromflussdauer bestimmten Entfernung von dem der Steuerelektrode gegenüberliegenden Rand der Emitterzone durch einen ringförmigen, zur Steuerelektrode konzentrischen Durchbruch der Basiszone unterteilt ist, und dass der daran anschliessende, von der Steuerelektrode entferntere Bereich eine durch die gewünschte Überstrombelastbarkeit bestimmte Flächenausdehnung aufweist.

Der ringförmige Durchbruch kann ein- oder mehrmals unterbrochen ausgebildet sein.

Eine Weiterbildung der Erfindung kann darin bestehen, dass der an den ringförmigen Durchbruch angrenzende, von der Steuerelektrode entferntere Bereich der Emitterfläche zumindest teilweise fein verteilte Durchbrüche aufweist.

Der Vorteil des Gegenstandes der Erfindung besteht in der gleichzeitigen Optimierung der Zündausbreitung, in dem Bereich der Stromflussdauer, der kritischen Spannungsanstiegsgeschwindigkeit du/dt und der Überstrombelastbarkeit.

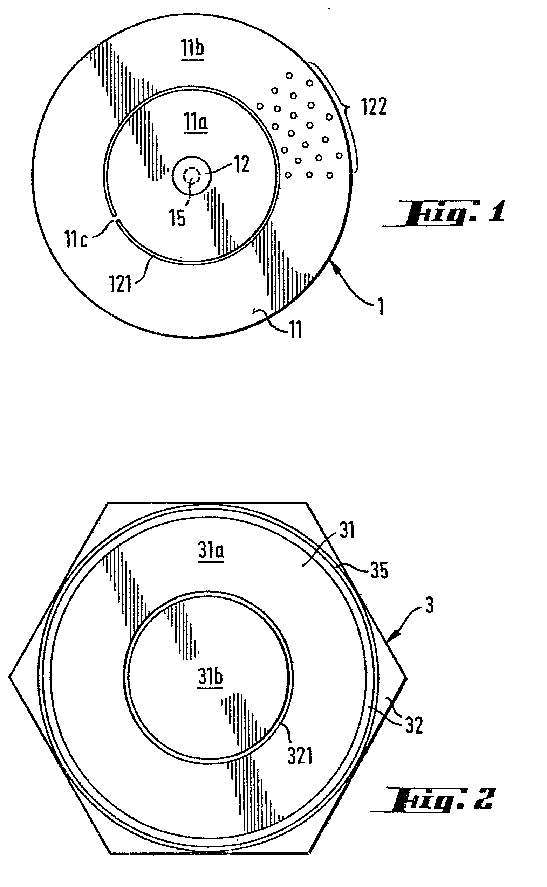

Anhand der in den Figuren 1 und 2 dargestellten Ausführungsbeispiele wird der Gegenstand der Erfindung aufgezeigt und erläutert. Figur 1 zeigt in Draufsicht den kreisscheibenförmigen Halbleiterkörper eines Thyristors mit Emitterzone, die eine zentrale Aussparung für eine Steuerelektrode aufweist, und mit einem die letztere konzentrisch einschliessenden, ringförmigen Durchbruch, und in Figur 2 ist ein sechseckförmiger Halbleiterkörper dargestellt, bei welchem eine ringförmige Steuerelektrode vorgesehen ist, die einen ringförmigen Durchbruch konzentrisch einschliesst.

Bei dem in Figur 1 gezeigten kreisscheibenförmigen Halbleiterkörper 1 ist die bis zur Mantelfläche verlaufende Emitterzone 11 durch den kreisringförmigen Durchbruch 121 in zwei konzentrische Teile 11a und 11b aufgeteilt. Der innere Bereich 11a weist eine zentrale Aussparung für die strichliniert dargestellte Steuerelektrode 15 auf, und zwischen dieser und dem inneren Rand des Bereiches 11a tritt die angrenzende Basiszone 12 an die Oberfläche. Die radiale Ausdehnung des Bereiches 11a wird durch die erforderliche Zündausbreitung bei der vorgesehenen Stromflussdauer bestimmt. Der Bereich 11a ist frei von Durchbrüchen der Basiszone. Der diesen Bereich 11a begrenzende ringförmige Durchbruch 121 kann eine oder mehrere Unterbrechungen aufweisen, wie dies mit 11c bezeichnet ist. Der ringförmige Durchbruch 121 ersetzt in vorteilhafter Weise eine Vielzahl von fein verteilten Durchbrüchen, welche in einem breiteren kreisringförmigen Bereich angeordnet werden müssten, um die Forderung nach bestmöglichem du/dt-Verhalten zu erfüllen. Bei einem solchen Flächenbereich mit vielen Durchbrüchen wäre jedoch die Optimierung der Zündausbreitung für die vorgesehene Stromflussdauer des Thyristors nicht gewährleistet.

Die Breite des ringförmigen Durchbruches 121 ist unkritisch. Für seine Fläche gilt die Forderung, dass sie im wesentlichen gleich der Gesamtfläche der bei bekannten Anordnungen vorgesehenen fein verteilten Durchbrüche in dem von dem Durchbruch 121 umschlossenen Bereich 11a der Emitterzone sein soll.

Der äussere Abschnitt 11b der Emitterzone kann fein verteilte Durchbrüche 122 aufweisen, wodurch allenfalls die Optimierung der Grösse du/dt gewährleistet ist. Die Flächenausdehnung der beiden Bereiche 11a und 11b bestimmt die Überstrombelastbarkeit des Halbleiterkörpers.

Figur 2 zeigt einen Halbleiterkörper in der für eine gute Flächennutzung einer grossflächigen Halbleiterausgangsscheibe besonders günstigen Sechseckform. Für den Halbleiterkörper 3 ist eine ringförmige Steuerelektrode 35 vorgesehen, die etwa entsprechend dem einbeschriebenen Kreis des Sechsecks verläuft. Auf beiden Seiten dieser kreisringförmigen Elektrode 35 tritt die an die Emitterzone angrenzende Basiszone 32 an die Oberfläche. Die Emitterzone 31 ist durch den ringförmigen Basiszonendurchbruch 321 in die konzentrischen Bereiche 31a und 31b unterteilt. Der äussere, der Steuerelektrode benachbarte Bereich 31a ist frei von Durchbrüchen. Nach Bedarf kann der zentrale Bereich 31b noch fein verteilte Durchbrüche aufweisen, wie dies in Figur 1 mit 122 dargestellt ist.

Der ringförmige Durchbruch 321 kann in Form von mehreren, voneinander getrennten Ringsegmenten ausgebildet sein.

Bei der Herstellung des Gegenstandes der Erfindung wird zunächst in einer Halbleiterscheibe des einen Leitfähigkeitstyps durch allseitiges Diffundieren von Störstellenmaterial des anderen Leitfähigkeitstyps eine pnp-Struktur erzeugt. Danach wird die Scheibe mit einer Oxidschicht versehen, die mit Hilfe eines Fotolackprozesses an den zur Ausbildung der Emitterzone vorgesehenen Flächenbereichen entfernt wird. Anschliessend werden durch Diffundieren von Dotierungsmaterial des einen Leitfähigkeitstyps die durch den ringförmigen Durchbruch 121 getrennten Emitterzonenbereiche 11a und 11b gebildet, und danach erfolgt das Anbringen der Steuerelektrode auf der Basiszone und der Laststromelektroden auf den Emitterflächen.

**Patentansprüche**

1. Thyristor mit kurzgeschlossenem Emitter für kurze Stromflussdauer, bei welchem der durch die Stromflussdauer bestimmte Bereich der Zündausbreitung frei von Durchbrüchen der Basiszone durch die Emitterzone ist, dadurch gekennzeichnet, dass die Emitterzone (11) in einer durch die vorgesehene Stromflussdauer bestimmten Entfernung von dem der Steuerelektrode gegenüberliegenden Rand der Emitterzone durch einen ringförmigen, zur Steuerelektrode konzentrischen Durchbruch (121, 321) der Basiszone unterteilt ist, und dass der daran anschliessende, von der Steuerelektrode entferntere Bereich (11b, 31b) eine durch die gewünschte Überstrombelastbarkeit bestimmte Flächenausdehnung aufweist.

2. Thyristor nach Anspruch 1, dadurch gekennzeichnet, dass der ringförmige Durchbruch (121, 321) aus zwei oder mehr Segmenten besteht.

3. Thyristor nach Anspruch 1 oder 2, dadurch gekennzeichnet, dass der an den ringförmigen Durchbruch (121, 321) anschliessende, von der Steuerelektrode entferntere Bereich (11b, 31b) zumindest teilweise fein verteilte Durchbrüche (122) aufweist.

**Claims**

1. Thyristor with short-circuited emitter for short current flow duration in which the region of the firing propagation determined by the current flow duration is free of penetrations of the base zone through the emitter zone, characterized in that the emitter zone (11) at a distance from the edge of the emitter zone facing the control electrode defined by the intended current flow duration is divided by an annular penetration (121, 321) of the base zone concentric with the control electrode, and that the adjoining region (11b, 31b) remoter from the control electrode comprises a surface extent defined by the desired excess current carrying capability.

2. Thyristor according to claim 1, characterized in that the annular penetration (121, 321) is composed of two or more segments.

3. Thyristor according to claim 1 or 2, characterized in that the region (11b, 31b) adjoining the annular penetration (121, 321) and remoter from the control electrode comprises at least in part finely dispersed penetrations (122).

**Revendications**

1. Thyristor avec un émetteur court-circuité pour des impulsions de courant de faible durée, où la zone de diffusion de l'amorçage déterminée par la durée des impulsions de courant est libre de zones de claquage traversant la zone émettrice depuis la zone de base, caractérisé en ce que la zone émettrice (11) est divisée, à une distance de son bord opposé à la gâchette ou électrode de commande, déterminée par la durée prévue de l'impulsion de courant, par une zone de claquage (121), (321) depuis la zone de base, annulaire, concentrique à la gâchette ou électrode de commande, et en ce que la zone adjacente (11b), (31b) éloignée de la gâchette ou électrode de commande, présente une superficie déterminée par la surintensité de courant admissible souhaitée.

2. Thyristor selon la revendication 1, caractérisé en ce que la zone de claquage annulaire (121), (321) est constituée de deux ou plusieurs segments.

3. Thyristor selon l'une des revendications 1 et 2, caractérisé en ce que la zone (11b), (31b) adjacente à la zone de claquage annulaire et éloignée de la gâchette ou électrode de commande comporte au moins partiellement des zones de claquage réparties finement.

*Fig. 1*

*Fig. 2*